# EUROPEAN PATENT SPECIFICATION

(11) **EP 2 432 028 B1**
(45) Date of publication and mention of the grant of the patent: **26.12.2018**
(21) Application number: 10820856.2
(22) Date of filing: 30.09.2010
(51) Int. Cl.: H01L 31/0236, H01L 31/032, H01L 31/0392, H01L 31/0468, H01L 31/0749, H01L 31/18, H02S 20/26

(54) **PHOTOVOLTAIC DEVICE**
PHOTOVOLTAIKVORRICHTUNG
DISPOSITIF PHOTOVOLTAÏQUE

(30) Priority: 30.09.2009 KR 20090093564; 30.10.2009 KR 20090104470
(43) Date of publication of application: 21.03.2012
(73) Proprietor: LG Innotek Co., Ltd., Seoul, 04637 (KR)
(72) Inventor: LIM, Chin Woo, Seoul 100-714 (KR); LEE, Seung Yup, Seoul 100-714 (KR)
(74) Representative: Novagraaf Technologies
(86) International application number: PCT/KR2010/006710
(87) International publication number: WO 2011/040783

(56) References cited:
- EP-A2- 0 877 427
- EP-A2- 1 143 530
- WO-A1-2009/017174
- WO-A2-2006/135438
- DE-A1- 4 324 647
- JP-A- 2002 094 089
- KR-A- 20080 107 434
- US-B2- 6 767 762

## Description

### BACKGROUND

The invention relates to a solar cell apparatus.

A solar cell module for converting photo energy into electric energy through the photoelectric transformation has been extensively used to obtain clean energy contributing to environmental conservation of the earth.

As the photo-electric transformation efficiency of a solar cell has been improved, a great number of solar cell systems having solar cell apparatuses are not only installed for home use, but also installed at the outer portion of a commercial building.

In other words, a BIPV (Building Integrated Photovoltaic) technology employing photovoltaic (PV) cells as finishing materials of buildings has been spotlighted.

In such a BIPVE technology, the finishing materials of the buildings must have desired performance and power must be supplied to the buildings based on self-power generation.

In particular, since lower and upper substrates having a predetermined thickness are used as the finishing materials of a solar cell module, the lightness of the lower and upper substrates is required. The US patent No. 6,767,762 discloses an ultra lightweight semiconductor device which comprises a substrate electrode, a body of semiconductor material and a top electrode. The ultra lightweight semiconductor device is manufactured by a process wherein the thickness dimension of a portion of the substrate electrode is decreased so as to reduce the weight of the device.

### SUMMARY

The invention provides a slim and light solar cell apparatus. In addition, the invention provides a solar cell apparatus, which can be used for windows of a building, have an improved outer appearance, and be easily manufactured.

According to the invention, which is defined in claim 1, a solar cell apparatus includes a substrate and a solar cell provided on the substrate. The substrate includes a support layer provided below the solar cell and a reinforcement part having an open region provided below the support layer to expose a bottom surface of the support layer.

According to the invention, a solar cell apparatus includes a substrate and a solar cell provided on the substrate. The substrate is provided on a bottom surface thereof with a pattern.

According to the invention, a method for manufacturing the solar cell apparatus includes forming a solar cell on a substrate and etching a lower portion of the substrate.

In the solar cell apparatus according to the invention, the lower portion of the substrate supporting the solar cells is partially removed. As described above, the lower portion of the substrate is partially removed to form the open region, so that the support layer and the reinforcement part can be formed.

In other words, a portion of the substrate is removed, so that the weigh of the support can be removed to about 50% to about 70%. In this case, when the portion of the substrate is removed, the reinforcement part reinforces the strength of the substrate. Accordingly, the slim and light solar cell apparatus according to the invention can be realized while maintaining the mechanical strength.

As the substrate obtains a slim shape, the substrate can be more flexible when the substrate includes polymer. The solar cell apparatus according to the invention can be variously used.

In the solar cell apparatus according to the invention, the protrusion pattern is formed on the bottom surface of the substrate. Accordingly, the protrusion pattern causes scattered-reflection to prevent light from being reflected from the bottom surface of the solar cell apparatus according to the invention.

In particular, when the solar cell apparatus according to the invention is used for the window, the bottom surface of the substrate is exposed inside a building. In this case, the protrusion pattern prevents the back electrode layer from being shown in the building through the substrate due to the scattered reflection.

In other words, inside the building, the shape of the layers formed on the substrate is not shown and the uniform outer appearance can be maintained.

Therefore, the solar cell apparatus according to the invention is used for the window with an improved fine view.

In addition, when the pattern is formed on the bottom surface of the substrate, the foreign matters can be simultaneously removed from the bottom surface of the substrate. Accordingly, when the solar cell apparatus according to the invention is formed, a process of removing the foreign matters is not additionally required.

Therefore, the solar cell apparatus according to the invention can be easily manufactured.

### BRIEF DESCRIPTION OF THE DRAWINGS

FIG. 1 is a plan view schematically showing a solar cell panel according to one embodiment not forming part of the invention;
FIG. 2 is a sectional view taken along line X-X' of FIG. 1;
FIG. 3 is a perspective view showing the rear surface of a support substrate;
FIG. 4 is a perspective view showing the rear surface of the support substrate of the solar cell panel according to another embodiment not forming part of the invention;
FIGS. 5 to 10 are sectional views showing the method for manufacturing the solar cell panel according to the one embodiment;
FIG. 11 is a sectional view showing the solar cell apparatus according to still another embodiment not forming part of the invention; and
FIGS. 12 to 15 are sectional views showing the manufacturing process of the solar cell apparatus according to the still another embodiment.

### DETAILED DESCRIPTION OF THE EMBODIMENTS

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" on the other substrate, layer (or film), region, pad, or pattern, or one or more intervening layers may also be present. Such a position of the layer has been described with reference to the drawings. The thickness and size of each layer shown in the drawings may be exaggerated, omitted or schematically drawn for the purpose of convenience or clarity. In addition, the size of elements does not utterly reflect an actual size.

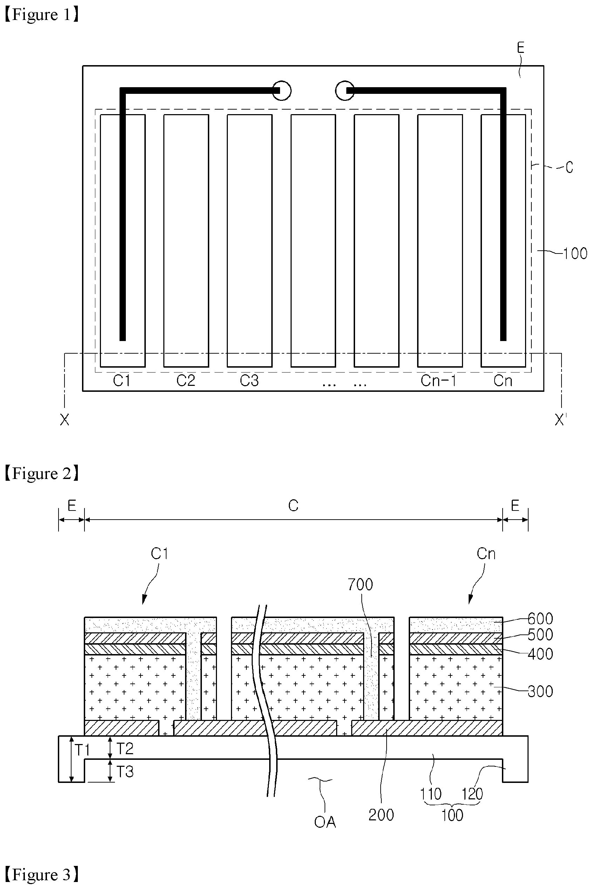

FIG. 1 is a plan view schematically showing a solar cell panel according to one embodiment not forming part of the invention, FIG. 2 is a sectional view taken along line X-X' of FIG. 1. FIG. 3 is a perspective view showing the rear surface of a support substrate.

Referring to FIGS. 1 to 3, the solar cell panel according to the embodiment includes a support substrate 100 and a plurality of solar cells C1, C2, ..., and Cn.

The support substrate 100 has a plate shape. The support substrate 100 is transparent and may be an insulator. The support substrate 100 may be rigid or flexible.

The support substrate 100 supports the solar cells C1, C2, ..., and Cn. The support substrate 100 includes a central region C at which the solar cells C1, C2, ..., and Cn are arranged and an edge region E surrounding the central region C. In other words, the edge region E has no solar cells C1, C2, ..., and Cn arranged therein. In other words, the central region C and the edge region E can be distinguished from each other by the solar cells C1, C2, ..., and Cn.

The support substrate 100 includes a support layer 110 and a reinforcement part 120.

The support layer 110 has a plate shape to support the solar cells C1, C2, ..., and Cn . The support layer 110 is arranged below the solar cells C1, C2, ..., and Cn. The support layer 110 has a thickness T2 of about 3mm to about 25mm.

The reinforcement part 120 is provided below the support layer 110. The reinforcement part 120 may be integrally formed with the support layer 110. The reinforcement part 120 reinforces the strength of the support layer 110. In particular, when the support substrate 100 is inserted into a frame, the reinforcement part 120 can reinforce the strength of the support substrate 100.

As shown in FIG. 3, the reinforcement part 120 may have the shape of extending with a long length. In detail, the reinforcement part 120 may have a closed loop. The reinforcement part 120 may have the shape of extending along the outer peripheral portion of the support layer 110. The reinforcement part 120 may be formed corresponding to the edge region E.

The reinforcement part 120 has an open region OA to expose the bottom surface of the support layer 110. In this case, the open region OA may correspond to the central region C. In other words, the plane shape of the open region OA may correspond to the plane shape of the central region C.

The thickness T3 of the reinforcement part 120 may be in the range of about 3mm to about 25mm. The thickness T1 of the support substrate 110, that is, the sum of the T3 of the reinforcement part 120 and the thickness T2 of the support layer 110 may be in the range of about 7mm to about 35mm. In addition, the ratio of the thickness T2 of the support layer 110 to the thickness T3 of the reinforcement part 120 may be about 3:7 to about 7:3.

The width of the reinforcement part 120 may vary depending on the size of the support layer 110. In other words, as the area of the support layer 110 is increased, the width of the reinforcement part 120 is increased. As the area of the support layer 110 is reduced, the width of the reinforcement part 120 may be reduced.

The support substrate 100 may include a glass substrate. In detail, the support substrate 100 may include a soda lime glass substrate. Accordingly, the support layer 110 and the reinforcement part 120 may include glass. In detail, the support layer 110 and the reinforcement part 120 may include glass.

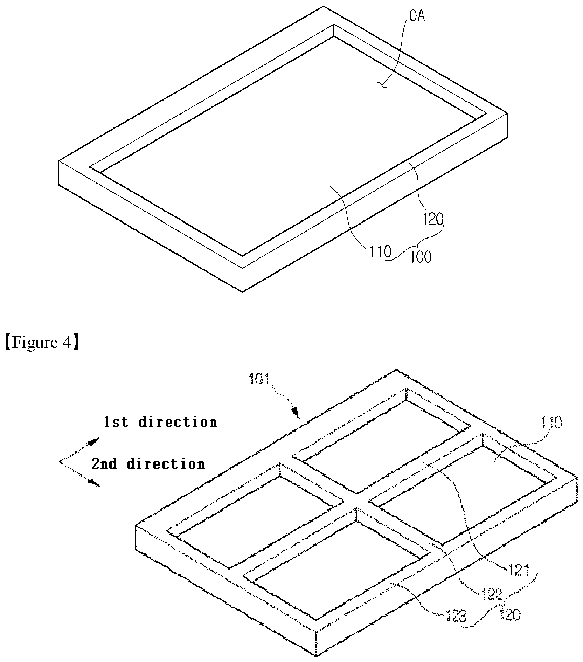

As shown in FIG. 4, the reinforcement part 120 may include the form of a lattice. In other words, the reinforcement part 120 may include a first reinforcement part 121, a second reinforcement part 122, and a third reinforcement part 123.

The first reinforcement part 121 may extend in the first direction, and the second reinforcement part 122 may extend in the second direction. In this case, the first reinforcement part 121 crosses the second reinforcement part 122. In detail, the first reinforcement part 121 may cross the second reinforcement part 122 in perpendicular to each other.

The third reinforcement part 123 connects the first reinforcement part 121 to the second reinforcement part 122. The third reinforcement part 123 may be arranged in the shape of a closed loop corresponding to the edge region E. In detail, the third reinforcement part 123 may have the shape of a rectangular frame.

The first reinforcement part 121, the second reinforcement part 122, and the third reinforcement part 123 may be integrally formed with each other. In detail, the first to third reinforcement parts 121 to 123 and the support layer 110 may be integrally formed with each other.

The solar cells C1, C2, ..., and Cn are provided on the support substrate 100. In detail, the solar cells C1, C2, ..., and Cn are provided on the support layer 110. The solar cells C1, C2, ..., and Cn are arranged in the central region C.

The solar cells C1, C2, ..., and Cn convert the light of the sun received therein into electrical energy. The solar cells C1, C2, .., and Cn may include semiconductor compound solar cells such as a CIGS-based solar cell, silicon-based solar cells, or dye-sensitized solar cells. The solar cells C1, C2, ..., and Cn may be connected to each other in series or in parallel.

The solar cells C1, C2, ..., and Cn may include a back electrode layer 200, a light absorbing layer 300, a buffer layer 400, a high-resistance buffer layer 500, and a window layer 600. In addition, the solar cells C1, C2, ..., and Cn may be connected to each other through a plurality of connection parts.

The back electrode layer 200 may include molybdenum (Mo). The light absorbing layer 300 may include a P-type CIGS-based semiconductor compound. In detail, the light absorbing layer 300 may include a Cu-In-Ga-Se based compound (Cu (In, Ga) Se₂;CIGS).

Since the support substrate 100 includes the open region OA, the weight of the support substrate 100 can be significantly reduced. In other words, the support substrate 100 including the open region OA may be formed by removing a lower portion of the glass substrate.

Accordingly, the weight of the support substrate 100 may be reduced to about 50% or less of the weight of the glass substrate.

In generally, the weight of the solar cell panel is substantially equal to that of the support substrate 100. In addition, since the process of forming the solar cells C1, C2, ..., and Cn are performed at the high temperature, the support substrate 100 must have a sufficient thickness when forming the solar cells C1, C2, ..., and Cn.

Since the weight of the support substrate 100 is reduced, the solar cell panel according to the embodiment can be reduced in weight.

In addition, since the thickness of the central region C is reduced, the solar cell panel according to the embodiment can be realized in the slimness shape.

In addition, even though the weight of the support substrate 100 is reduced, the strength of the support layer 110 is reinforced by the reinforcement part 120. Accordingly, the strength of the support substrate 100 can be maintained.

Meanwhile, although the embodiment has been described in that the open region OA has the form of one groove, the open region OA may have various forms.

For example, the open region OA may be provided in the rectangular shape having right-angled corners. In addition, the open region OA may be provided in a hemispherical shape having curved corners. In addition, the open region OA has a small width, and at least one open region OA may be provided.

Therefore, a slim, light, and small solar cell panel can be realized.

In addition, since the support substrate 100 may include a more flexible material and have a more flexible structure corresponding to the slimness of the support substrate 100, the support substrate 100 is applicable to various fields.

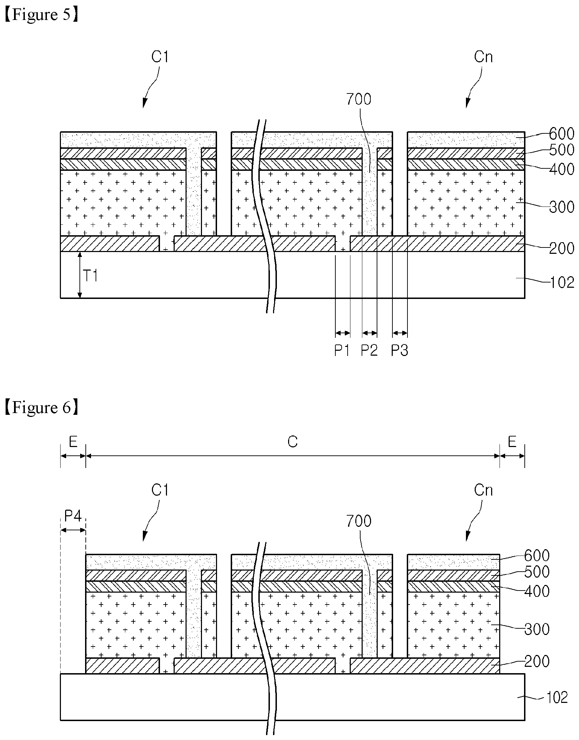

FIGS. 5 to 10 are sectional views showing the manufacturing process of the solar cell panel according to one embodiment not forming part of the invention. A method for manufacturing the solar cell will be described by making reference to the description about the solar cell panel. In other words, the description about the solar cell panel will be incorporated with the description about the method for manufacturing the same.

Referring to FIG. 5, a plurality of solar cells C1, C2, ..., and Cn are formed on a preliminary support substrate 102. The back electrode layer 200 is formed on the preliminary support substrate 102.

The preliminary support substrate 102 has a plate shape. The preliminary support substrate 102 may include a glass substrate. In addition, the preliminary support substrate 102 may include a ceramic substrate, a metallic substrate, or a polymer substrate.

For example, the glass substrate may include soda lime glass or high strained point soda glass. The metallic substrate may include stainless steel or titanium (Ti). The polymer substrate may include a polyimide substrate.

The preliminary support substrate 102 may be transparent. The preliminary support substrate 102 may be rigid or flexible.

Since the process of forming the light absorbing layer 300 thereafter can be performed at a high temperature, the preliminary support substrate 102 must have a sufficient thickness. For example, the thickness T1 of the preliminary support substrate 110 may be in the range of about 7mm to about 35mm.

The back electrode layer 200 may include a conductor such as metal. For example, the back electrode layer 200 may be formed through a sputtering process employing a molybdenum (Mo) target. This is because Mo represents high electrical conductivity, makes ohmic-contact with the light absorbing layer 300, and represents high-temperature stability under the atmosphere of Se.

A molybdenum thin film, which serves as the back electrode layer 200, represents low resistivity as an electrode. In addition, since the Mo thin film is not delaminated due to the difference in a thermal coefficient, the Mo thin film has a high adhesion property with respect to the support substrate 102.

Meanwhile, the material constituting the back electrode layer 200 is not limited thereto, but may include Mo doped with Na ions.

Although not shown, the back electrode layer 200 may include at least one layer. When the back electrode layer 200 includes a plurality of layers, the layers constituting the back electrode layer 200 may include different materials.

A plurality of first through holes P1 are formed in the back electrode layer 200, and the back electrode layer 200 may be patterned. The first through holes P1 may expose the top surface of the preliminary support substrate 102.

The light absorbing layer 300 is formed on the back electrode layer 200. The light absorbing layer 300 includes b- b- b-based compounds.

In detail, the light absorbing layer 300 include Cu (In, Ga) Se₂ (CIGS)-based compounds. In addition, the light absorbing layer 300 may include CuInSe₂ (CIS)-based compounds or CuGaSe₂ (CGS)-based compounds.

For example, in order to form the light absorbing layer 300, a CIG-based metallic precursor layer is formed on the back electrode layer 200 by using a copper target, an indium target, and a gallium target.

Thereafter, the metallic precursor layer reacts with the Se through a selenization process, thereby forming the CIGS-based light absorbing layer 300.

In addition, the light absorbing layer 300 may be formed by performing a co-evaporation process for Cu, In, Ga, and Se.

The light absorbing layer 300 receives external light and converts the light into electrical energy. The light absorbing layer 300 generates photovoltaic power through the photo-electric effects.

Thereafter, the buffer layer 400 and the high-resistance buffer layer 500 are formed on the light absorbing layer 300.

At least one buffer layer 400 may be formed on the light absorbing layer 300. The buffer layer 400 may be formed by using cadmium sulfide (CdS) through a chemical bath deposition (CBD) process.

In this case, the buffer layer 400 is an N type semiconductor layer, and the light absorbing layer 300 is a P type semiconductor layer. Accordingly, the light absorbing layer 300 and the buffer layer 400 make a PN junction.

The high-resistance buffer layer 500 may be formed as a transparent electrode layer on the buffer layer 400.

For example, the high-resistance buffer layer 500 may include one of ITO, ZnO, and i-ZnO.

The high-resistance buffer layer 500 may include a zinc oxide (ZnO) layer formed through a sputtering process employing a ZnO target.

The buffer layer 400 and the high-resistance buffer layer 500 are interposed between the light absorbing layer 300 and the window layer 600 which is formed thereafter.

In other words, since the light absorbing layer 300 and the window layer 600 make a great difference in a lattice constant and an energy band gap, the buffer layer 400 and the high-resistance buffer layer 500 having intermediate band gaps of the above two layers are interposed between the two layers, so that the light absorbing layer 300 and the window layer 600 can be greatly bonded to each other.

Although the two buffer layers 400 are formed on the light absorbing layer 300 according to the present embodiment, the present embodiment is not limited thereto. In other words, a single buffer layer 400 may be provided.

Thereafter, a plurality of second through holes P2 are formed through the high-resistance buffer layer 500, the buffer layer 400, and the light absorbing layer 300.

The second through holes P2 may expose a portion of the back electrode layer 200. The second through holes P2 may be adjacent to the first through holes P1.

Subsequently, the window layer 600 is formed by stacking a transparent conductive material on the high-resistance buffer layer 500.

When the window layer 600 is formed, the transparent conductive material is inserted into the second through holes P2, thereby forming a plurality of connection wires 700.

The window layer 600 may include zinc oxide doped with Al or Al2O3 through the sputtering process.

Since the window layer 600 makes a PN junction with the light absorbing layer 300 and serves as a transparent electrode with respect to the entire surface of the solar cell, the window layer 600 may include ZnO representing high transmittance and superior electrical conductivity.

Therefore, the window layer 600 may include an electrode having low resistance formed by doping ZnO with Al or Al₂O₃.

The ZnO layer serving as the window layer 600 may be formed by depositing a ZnO target through a RF sputtering scheme, a reactive sputtering scheme using a Zn target, or a metal organic chemical vapor deposition scheme.

The window layer 600 may include a double structure formed by depositing an indium tin oxide thin (ITO) film representing a superior electro-optical characteristic on a ZnO thin film.

Next, a plurality of third through holes P3 are formed through the window layer 600, the high-resistance buffer layer 500, the buffer layer 400, and the light absorbing layer 300.

The third through holes P3 can selectively expose the back electrode layer 200. The third through holes P3 may be adjacent to the second through holes P2.

The light absorbing layer 300, the buffer layer 400, the high-resistance buffer layer 500, and the window layer 600 can be separated from each other according to the solar cells by the third through holes P3. In other words, the solar cells C1, C2... and Cn can be defined by the third through holes P3.

Referring to FIG. 6, the outer peripheral portions of the back electrode layer 200, the light absorbing layer 300, the buffer layer 400, the high-resistance buffer layer 500, and the window layer 600 are removed. Therefore, the central region C and the edge region E are provided.

In other words, the removed outer peripheral portion corresponds to the edge region E, and the remaining portion for the solar cells C1, C2,..., and Cn corresponds to the central region C. The removed outer peripheral portion is defined as a fourth through hole P4. In other words, the edge region E of the preliminary support substrate 102 is exposed by the fourth through hole P4.

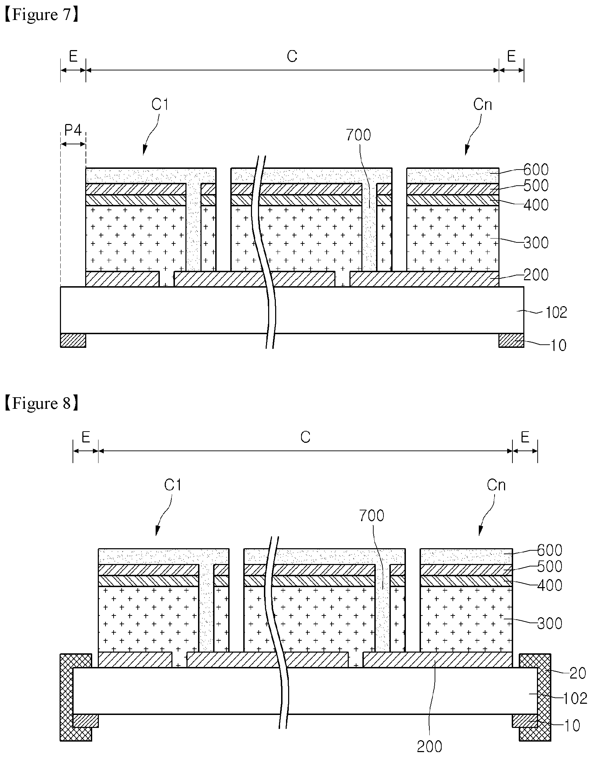

Referring to FIG. 7, a hard mask 10 is formed on a bottom surface of the preliminary support substrate 102. In detail, the hard mask 10 is provided on the bottom surface of the preliminary support substrate 102 corresponding to the edge region E.

For example, the hard mask 10 may include one of a metallic material, an insulating material, and a polymer material.

The hard mask 10 is used to selectively protect the bottom surface of the preliminary support substrate 102 through an etching process performed thereafter.

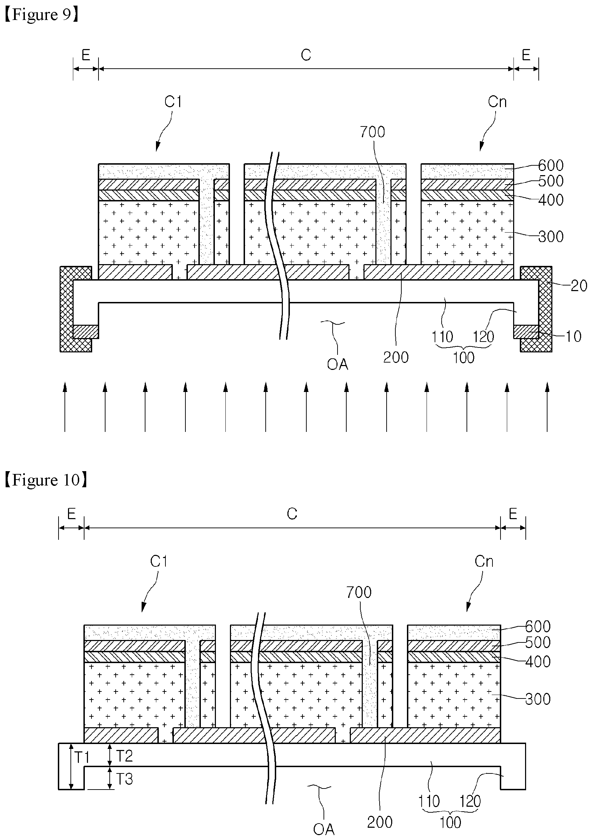

Referring to FIGS. 8 and 9, the lower portion of the preliminary support substrate 102 is etched so that the support substrate 100 including the support layer 110 and the reinforcement part 120 is formed. In other words, the lower portion of the preliminary support substrate 102 is etched to form the open region OA.

The open region OA may correspond to the central region C. In other words, the open region OA may be formed at the same position as that of the central region C in the same shape as that of the central region C. The open region OA may be formed by selectively etching the lower portion of the preliminary support substrate 102. In other words, the open region OA may be formed at the lower portion of the preliminary support substrate 102 without the region for the hard mask 10.

Hereinafter, a method for etching the lower portion of the preliminary support substrate 102 will be described in detail.

As shown in FIG. 8, the preliminary support substrate 102 is fixed by a frame 20. The frame 20 may be combined with the edge region E of the preliminary support substrate 102. In particular, the frame 20 fixes the preliminary support substrate 102 while making contact with the hard mask 10 and the preliminary support substrate 102 corresponding to the edge region E.

Etching solution or etching gas is sprayed on the bottom surface of the preliminary support substrate 102 as shown in FIG. 6, so that the lower portion for the preliminary support substrate 102 is etched. Accordingly, the support substrate 100 including the open region OA is formed.

The etching process may be performed by supplying etchant to the lower portion of the preliminary support substrate 102. For example, the preliminary support substrate 102 is dipped into the bath containing the etchant, so that the preliminary support substrate 102 can be etched. The etchant may include hydrogen fluoride (HF)-based etching solution.

In this case, the hard mask 10 is formed on the bottom surface of the preliminary support substrate 102 corresponding to the edge region E. Accordingly, only the central region C of the preliminary support substrate 102 corresponding to the inside of the edge region E is selectively etched, so that the open region OA may be formed.

In addition, the open region OA may be performed through a dry etching process employing the hard mask 10 as an etching mask. In the dry etching process, hydrogen fluoride-based gas may be used.

Although the open region OA is formed at the central region C of the lower portion of the preliminary support substrate 102 except for the edge region E, the embodiment is not limited thereto.

In other words, the open region OA may have a curved bottom surface. In addition, after at least one hard mask 10 used to form the open region OA is provided at the central region C of the bottom surface of the preliminary support substrate 102, the etching process can be performed. Therefore, the lower portion of the preliminary support substrate 102 may be etched in the desired shape. In particular, the lower portion of the preliminary support substrate 102 may be etched in the shape shown in FIG. 4 as described above.

Referring to FIG. 10, the hard mask 10 may be removed through a typical stripping process.

In the typical solar cell panel, the weight of the support substrate 100 having a plate shape occupies most of the weight of the solar cell panel. Since the preliminary support substrate 102 is selectively removed according to the present embodiment, the weight of the support substrate 100 can be reduced.

The weight of the support substrate 100 can be reduced to about 50% or less of the weight of the preliminary support substrate 102.

Therefore, the whole weight of the solar cell panel according to the embodiment is reduced, so that a slim, light, and small solar cell panel according to the embodiment can be realized.

The solar cell panel according to the present embodiment corresponds to the solar cell apparatus. Accordingly, the present embodiment is applicable to the solar cell apparatus.

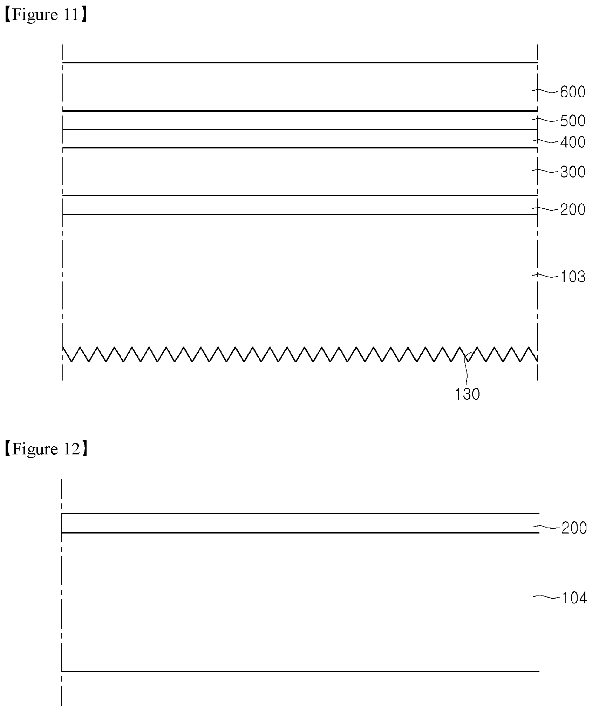

FIG. 11 is a sectional view showing a solar cell apparatus according to another embodiment not forming part of the invention. The present embodiment will be described by making reference to the description about the previous embodiment. In other words, the description about the previous embodiments will be incorporated with the description about the present embodiment.

Referring to FIG. 11, the solar cell apparatus according to the present embodiment includes a support substrate 103, the back electrode layer 200, the light absorbing layer 300, the buffer layer 400, the high-resistance buffer layer 500, and the window layer 500.

The back electrode layer 200, the light absorbing layer 300, the buffer layer 400, the high-resistance buffer layer 500, and the window layer 600 can constitute one or a plurality of solar cells. In other words, the solar cell apparatus according to the embodiment includes the support substrate 103 and one or a plurality of solar cells provided on the support substrate 103.

The support substrate 103 has a plate shape to support the back electrode layer 200, the light absorbing layer 300, the buffer layer 400, the high-resistance buffer layer 500, and the window layer 600.

The support substrate 103 may include an insulator. The support substrate 103 may include a glass substrate or a plastic substrate. In detail, the support substrate 103 may include a soda lime glass substrate. The support substrate 103 may be rigid or flexible.

A pattern 130 is formed on the bottom surface of the support substrate 103. The pattern 130 may have various shapes. For example, the pattern 130 may include protrusion patterns randomly formed.

The scattered-reflection may occur on the bottom surface of the support substrate 103 by the pattern 130. In other words, the support substrate 103 is semitransparent by the pattern 130. The intensity of illumination in the bottom surface of the support substrate 103 may be in the range of about 0.008*µ*m to about 0.023*µ*m.

The back electrode layer 200 is provided on the support substrate 103. The back electrode layer 200 is a conductive layer. The material constituting the back electrode layer 200 may include metal such as Mo.

In addition, the back electrode layer 200 may include at least two layers. In this case, the layers may include the same material or different metals.

The light absorbing part 300 may be formed on the back electrode layer 200. The light absorbing part 300 may include group I-III-V compounds. For example, the light absorbing part 300 may have a Cu-In-Ga-Se-based crystal structure (Cu (In, Ga) Se₂;CIGS), a Cu-In-Se-based crystal structure, or a Cu-Ga-Se based crystal structure.

The band gap of the light absorbing layer 300 may be in the range of about leV to about 1.8eV.

The buffer layer 400 is provided on the light absorbing layer 300. The material constituting the buffer layer 400 may include CdS. The buffer layer 400 may have a thickness of about 50nm to about 150nm. In addition, the band gap energy of the buffer layer 400 may be in the range of about 2.0eV to about 2.5eV.

The high-resistance buffer layer 500 is provided on the buffer layer 400. The high-resistance buffer layer 500 includes i-ZnO that is not doped with impurities. The high-resistance buffer layer 500 has the energy band gap in the range of about 3.1eV to about 3.3eV.

The window layer 600 is provided on the high-resistance buffer layer 500. The window layer 600 is transparent, and includes a conductive layer. The material constituting the window layer 600 may include Al doped ZnO (AZO).

In the solar cell apparatus according to the embodiment, the pattern 130 causes the scattered-reflection, thereby preventing light from being reflected from the bottom surface.

In particular, when the solar cell apparatus according to the embodiment is used for a window, the bottom surface of the support substrate 103 is exposed to the inside of the building. In this case, the pattern 130 prevents the back electrode layer 200 from being shown in the building through the support substrate 103 due to the scattered-reflection.

In other words, inside the building, the patterns of layers formed on the support substrate 103 are not shown, but a uniform outer appearance can be maintained.

Therefore, the solar cell apparatus according to the present embodiment can be used for a window with an improved outer appearance.

FIGS. 12 to 15 are sectional views showing the manufacturing process of a solar cell apparatus according to another embodiment not forming part of the invention. A method for manufacturing the solar cell apparatus according to the present embodiment will be described by making reference to the description about the solar cell apparatus according to the previous embodiment. In other words, the description about the solar cell apparatus according to the previous embodiment will be incorporated with the description about the method for manufacturing the same according to the present embodiment.

Referring to FIG. 12, the back electrode layer 200 is formed by depositing metal such as Mo on a preliminary support substrate 104 through a sputtering process. The back electrode layer 200 may be formed through two processes having different process conditions.

An additional layer such as an anti-diffusion layer may be interposed between the preliminary support substrate 104 and the back electrode layer 200.

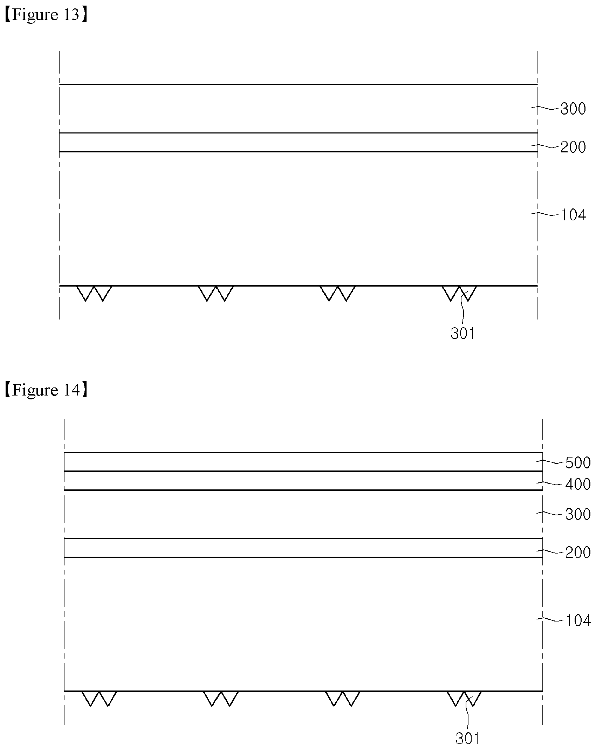

Referring to FIG. 13, the light absorbing layer 300 is formed on the back electrode layer 200.

The light absorbing layer 300 may be formed through a sputtering process or an evaporation scheme.

For example, the light absorbing layer 300 may be formed through various schemes such as a scheme of forming a Cu (In, Ga) Se₂ (CIGS) based-light absorbing layer 300 by simultaneously or separately evaporating Cu, In, Ga, and Se and a scheme of performing a selenization process after a metallic precursor film has been formed.

Regarding the details of the selenization process after the formation of the metallic precursor layer, the metallic precursor layer is formed on the back contact electrode 200 through a sputtering process employing a Cu target, an In target, or a Ga target.

Thereafter, the metallic precursor layer is subject to the selenization process so that the Cu (In, Ga) Se₂ (CIGS) based-light absorbing layer 300 is formed.

In addition, the sputtering process employing the Cu target, the In target, and the Ga target and the selenization process may be simultaneously performed.

In addition, a CIS or a CIG light absorbing layer 300 may be formed through a sputtering process employing only Cu and In targets or only Cu and Ga targets and the selenization process.

In this case, foreign matters 301 may be attached to the bottom surface of the preliminary support substrate 104. For example, Se may be deposited on the bottom surface of the preliminary support substrate 104. In particular, since Se is deposited on the back electrode layer 200 through the evaporation scheme, the Se may be easily deposited even on the bottom surface of the preliminary support substrate 104.

As shown in FIG. 14, the buffer layer 400 is formed on the light absorbing layer 300.

The buffer layer 400 may be formed through a CBD (chemical bath deposition) scheme.

In order to form the buffer layer 400, a solution containing supersaturated ions used to form the buffer layer 400 may be formed by using supersaturated solution. For example, the solution may contain Cd2+ and S2- in the supersaturated state.

In detail, the solution may contain cadmium acetate and thiourea, and may further contain buffer and ammonia.

Thereafter, the light absorbing layer 300 is dipped into the solution. In other words, the light absorbing layer 300 directly makes contact with the solution, so that the buffer layer 400 is formed on the light absorbing layer 300 through a chemical reaction. In this case, the reaction temperature may be in the range of about 60 to about 80 . In addition, the reaction time may be in the range of about 10 minutes to about 15 minutes.

Thereafter, zinc oxide, which is not doped with impurities, is deposited on the buffer layer 400 through a sputtering process, and the high-resistance buffer layer 500 is formed.

Next, the window layer 600 is formed on the high-resistance buffer layer 500. In order to form the window layer 600, a transparent conductive material is stacked on the high-resistance buffer layer 500. The transparent material may include zinc oxide (ZnO) doped with aluminum (Al).

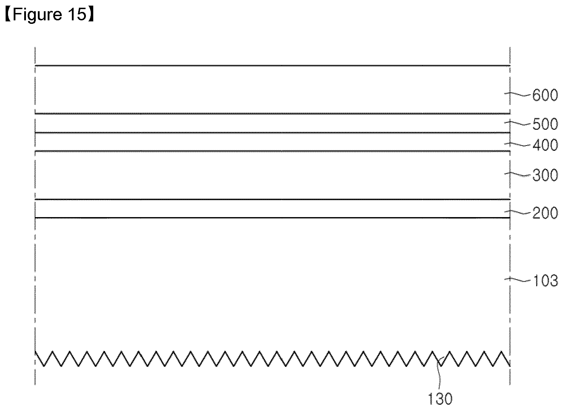

Referring to FIG. 15, after the window layer 600 is formed, the bottom surface of the preliminary support substrate 104 is patterned. Accordingly, the support substrate 103 including fine patterns 130 formed on the bottom surface thereof is formed. In addition, the foreign matters 301 are removed from the bottom surface of the preliminary support substrate 104 through the patterning process.

The bottom surface of the preliminary support substrate 104 is subject to the surface-treatment through the sand blast process, so that the pattern 130 may be formed. Simultaneously, the foreign matters 301 may be removed.

In other words, fine sands are sprayed on the bottom surface of the preliminary support substrate 104 together with compressed air, and the bottom surface of the preliminary support substrate 104 is etched, thereby forming the fine pattern 130. Simultaneously, the foreign matters 301 are removed by the sand.

In the method for manufacturing the solar cell apparatus according to the invention, the removing the foreign matters from the bottom surface of the preliminary support substrate 104 and the forming the pattern are performed through one process.

In addition, the method for manufacturing the solar cell apparatus according to the invention will be easily performed.

As described above, although the embodiments are separately described, the embodiments can be combined with each other. In the solar cell apparatus described with reference to FIGS. 1 to 10, when the lower portion of the preliminary support substrate 102 is etched, the foreign matters are removed from the bottom surface of the preliminary support substrate 102. According to the embodiment of the invention, as the lower portion of the support substrate 102 is etched, fine patterns can be formed on the bottom surface of the support substrate 100 of FIGS. 1 to 10, in detail, on the bottom surface of the support layer 110.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

The solar cell apparatus according to the invention is applicable to the field of the solar power generation.

## Claims

1. A solar cell apparatus comprising:
a substrate (100, 103) that is transparent; and
a solar cell on a top surface of the substrate (100, 103), wherein the substrate (100, 103) comprises:
a support layer (110) below the solar cell; and
a reinforcement part (120) provided below the support layer and having an open region (OA) to expose a bottom surface of the support layer (110),
the solar cell apparatus being **characterized in that** the substrate is provided on a bottom surface thereof with a semitransparent protrusion pattern (130) arranged to prevent light from being reflected from the bottom surface.

2. The solar cell apparatus of claim 1, wherein the support layer (110) is integrally formed with the reinforcement part (120) .

3. The solar cell apparatus of claim 1, wherein the reinforcement part (120) extends along an outer peripheral portion of the support layer (110).

4. The solar cell apparatus of claim 1, wherein a ratio of a thickness of the support layer (110) to a thickness of the reinforcement part (120) is 7:3 to 3:7.

5. The solar cell apparatus of claim 1, wherein the support layer (110) and the reinforcement part (120) include glass.

6. The solar cell apparatus of claim 1, wherein the reinforcement part (120) comprises:
a first reinforcement (121) part extending in one direction; and
a second reinforcement part (122) integrally formed with the first reinforcement part (121) while crossing the first reinforcement part (121).

7. The solar cell apparatus of claim 6, further comprising a third reinforcement part (123) connected to the first and second reinforcement parts, wherein the third reinforcement part (123) extends along an outer peripheral portion of the support layer (110).

8. The solar cell apparatus of claim 1, wherein the reinforcement part has a form of a lattice.

9. The solar cell apparatus of claim 1, wherein the substrate comprises a central region provided therein with the solar cell, and an edge region surrounding the central region, and the open region corresponds to the central region.

10. The solar cell apparatus of claim 9, wherein the reinforcement part corresponds to the edge region.

11. The solar cell apparatus of claim 1, wherein the solar cell comprises a back electrode (200) provided on a top surface of the substrate, and the back electrode (200) includes opaque metal.

## Patentansprüche

1. Solarzellenvorrichtung, umfassend:
ein Substrat (100, 103), das transparent ist; und
eine Solarzelle auf einer Deckfläche des Substrats (100, 103),
wobei das Substrat (100, 103) umfasst:
eine Tragschicht (110) unter der Solarzelle; und
ein Verstärkungsteil (120), das unter der Tragschicht bereitgestellt ist und einen offenen Bereich (OA) aufweist, um eine Bodenfläche der Tragschicht (110) freizulegen,
wobei die Solarzellenvorrichtung **dadurch gekennzeichnet ist, dass** das Substrat an einer Bodenfläche desselben mit einem halbtransparenten Vorsprungsmuster (130) versehen ist, das so eingerichtet ist, dass es Licht davon abhält, von der Bodenfläche reflektiert zu werden.

2. Solarzellenvorrichtung nach Anspruch 1, wobei die Tragschicht (110) einstückig mit dem Verstärkungsteil (120) gebildet ist.

3. Solarzellenvorrichtung nach Anspruch 1, wobei sich das Verstärkungsteil (120) entlang einem äußeren Umfangsabschnitt der Tragschicht (110) erstreckt.

4. Solarzellenvorrichtung nach Anspruch 1, wobei ein Verhältnis einer Dicke der Tragschicht (110) zu einer Dicke des Verstärkungsteils (120) 7:3 bis 3:7 beträgt.

5. Solarzellenvorrichtung nach Anspruch 1, wobei die Tragschicht (110) und das Verstärkungsteil (120) Glas beinhalten.

6. Solarzellenvorrichtung nach Anspruch 1, wobei das Verstärkungsteil (120) umfasst:
ein erstes Verstärkungsteil (121), das sich in eine Richtung erstreckt; und
ein zweites Verstärkungsteil (122), das einstückig mit dem ersten Verstärkungsteil (121) gebildet ist, während es das erste Verstärkungsteil (121) kreuzt.

7. Solarzellenvorrichtung nach Anspruch 6, weiter ein drittes Verstärkungsteil (123) umfassend, das mit dem ersten und zweiten Verstärkungsteil verbunden ist, wobei sich das dritte Verstärkungsteil (123) entlang einem Außenumfangsabschnitt der Tragschicht (110) erstreckt.

8. Solarzellenvorrichtung nach Anspruch 1, wobei das Verstärkungsteil eine Form eines Gitters aufweist.

9. Solarzellenvorrichtung nach Anspruch 1, wobei das Substrat einen mittleren Bereich, der in demselben mit der Solarzelle versehen ist, und einen den mittleren Bereich umgebenden Randbereich umfasst, und der offene Bereich dem mittleren Bereich entspricht.

10. Solarzellenvorrichtung nach Anspruch 9, wobei das Verstärkungsteil dem Randbereich entspricht.

11. Solarzellenvorrichtung nach Anspruch 1, wobei die Solarzelle eine Rückelektrode (200) aufweist, die auf einer Deckfläche des Substrats bereitgestellt ist, und die Rückelektrode (200) undurchlässiges Metall beinhaltet.

## Revendications

1. Appareil à cellule solaire comprenant :
un substrat (100, 103) qui est transparent ; et
une cellule solaire sur une surface supérieure du substrat (100, 103),
dans lequel le substrat (100, 103) comprend :
une couche de support (110) sous la cellule solaire ; et
une partie de renfort (120) fournie sous la couche de support et ayant une région ouverte (OA) pour exposer une surface inférieure de la couche de support (110),
l'appareil à cellule solaire étant **caractérisé en ce que** le substrat est doté sur une surface inférieure de celui-ci d'un motif en saillie semi-transparent (130) agencé pour empêcher la lumière d'être réfléchie par la surface inférieure.

2. Appareil à cellule solaire selon la revendication 1, dans lequel la couche de support (110) est formée d'un seul tenant avec la partie de renfort (120).

3. Appareil à cellule solaire selon la revendication 1, dans lequel la partie de renfort (120) s'étend le long d'une portion périphérique externe de la couche de support (110).

4. Appareil à cellule solaire selon la revendication 1, dans lequel un rapport d'une épaisseur de la couche de support (110) à une épaisseur de la partie de renfort (120) est de 7/3 à 3/7.

5. Appareil à cellule solaire selon la revendication 1, dans lequel la couche de support (110) et la partie de renfort (120) incluent du verre.

6. Appareil à cellule solaire selon la revendication 1, dans lequel la partie de renfort (120) comprend :
une première partie de renfort (121) s'étendant dans une direction ; et
une deuxième partie de renfort (122) formée d'un seul tenant avec la première partie de renfort (121) tout en croisant la première partie de renfort (121).

7. Appareil à cellule solaire selon la revendication 6, comprenant en outre une troisième partie de renfort (123) raccordée aux première et deuxième parties de renfort, dans lequel la troisième partie de renfort (123) s'étend le long d'une portion périphérique externe de la couche de support (110).

8. Appareil à cellule solaire selon la revendication 1, dans lequel la partie de renfort a une forme d'un réseau.

9. Appareil à cellule solaire selon la revendication 1, dans lequel le substrat comprend une région centrale dotée à l'intérieur de celui-ci de la cellule solaire, et une région marginale entourant la région centrale, et la région ouverte correspond à la région centrale.

10. Appareil à cellule solaire selon la revendication 9, dans lequel la partie de renfort correspond à la région marginale.

11. Appareil à cellule solaire selon la revendication 1, dans lequel la cellule solaire comprend une électrode arrière (200) fournie sur une surface supérieure du substrat, et l'électrode arrière (200) inclut un métal opaque.
